# EUROPÄISCHE PATENTSCHRIFT

(11) **EP 0 729 176 B1**
(45) Veröffentlichungstag und Bekanntmachung des Hinweises auf die Patenterteilung: **02.05.2002**
(21) Anmeldenummer: 96101674.8
(22) Anmeldetag: 06.02.1996
(51) Int. Cl.: H01L 21/3065, H01L 21/304, H01L 21/302, H01L 21/78

(54) **Verfahren zum Damage-Ätzen der Rückseite einer Halbleiterscheibe bei geschützter Scheibenvorderseite**
Process of damage etching the backside of a semiconductor wafer with protected wafer frontside
Procédé d'attaque de la face arrière d'une plaquette semi-conductrice pour l'élimination de défauts de surface, la face avant étant protégée

(30) Priorität: 21.02.1995 DE 19505906
(43) Veröffentlichungstag der Anmeldung: 28.08.1996
(73) Patentinhaber: Infineon Technologies AG, 81669 München (DE)
(72) Erfinder: Mathuni Josef, Dr. Dipl.-Phys., D-81737 München (DE)
(74) Vertreter: Kindermann, Peter, Dipl.-Ing.

(56) Entgegenhaltungen:
- EP-A- 0 182 218
- US-A- 4 946 547
- US-A- 5 268 065
- COOK J M: "DOWNSTREAM PLASMA ETCHING AND STRIPPING" SOLID STATE TECHNOLOGY, Bd. 30, Nr. 4, 1.April 1987, Seiten 147-151, XP000097438
- OHKAWA K ET AL: "HOMOEPITAXIAL GROWTH OF ZNSE ON DRY-ETCHED SUBSTRATES" APPLIED PHYSICS LETTERS, Bd. 54, Nr. 25, 19.Juni 1989, Seiten 2553-2555, XP000046656
- MASANORI NISHIGUCHI ET AL: "MECHANICAL THINNING OF INP WAFER BY GRINDING" JOURNAL OF THE ELECTROCHEMICAL SOCIETY, Bd. 138, Nr. 6, 1.Juni 1991, Seiten 1826-1831, XP000208345
- PATENT ABSTRACTS OF JAPAN vol. 015, no. 159 (E-1059), 22.April 1991 & JP 03 030326 A (MITSUBISHI ELECTRIC CORP), 8.Februar 1991,

## Beschreibung

Die Erfindung betrifft ein Verfahren zur Herstellung von hochintegrierten Schaltungen auf einem scheibenförmigen Si-Substrat, bei dem die Scheiben dünn geschliffen werden, um dann zu einzelnen Chips zersägt zu werden und bei dem die durch den Schleifprozeß verursachte Damagezone auf der Scheibenrückseite durch eine bei geschützter Scheibenvorderseite und vor dem Zersägen durchgeführte Ätzung wieder entfernt wird.

Am Ende des Herstellungsprozesses von Silizium-Scheiben mit Halbleiterbauelementen werden die Scheiben dünn geschliffen, um dann zu einzelnen Chips zersägt zu werden. Dieser Schleifprozeß hinterläßt auf der Scheibenrückseite eine von feinen Rissen überzogene, gestörte und daher unter Spannung stehende Silizium-Oberfläche. Sind die Scheiben sehr dünn geschliffen (z. B. für Chipkartenanwendungen < 200µm), so können sie beim anschließenden Sägen oder danach infolgedessen sehr leicht brechen. Hierbei spielen auch die Störungen und Spannungen, die durch das Sägen selbst in der Sägekante entstehen, eine Rolle.

Um ein unkontrolliertes und zu frühes Brechen zu verhindern, wird die Scheibenrückseite gemäß US 5,268,065 in einer Naßätze um mehrere Mikrometer abgeätzt und damit die Spannung verursachende Damagezone entfernt. Die Scheibenvorderseite wird dabei üblicherweise von einer dicken (etwa 100 µm) Folie geschützt, die auch am Scheibenrand ganz dicht sein muß, so daß die Notwendigkeit einer zusätzlichen Belackung der Scheiben vor Aufbringung der Folie entfallen kann, die andernfalls vorgenommen werden müßte, um eine Zerstörung von Randchips durch die Naßätzung zu verhindern.

Dieses Verfahren hat jedoch einige schwerwiegende Nachteile: Nach dem Naß-Rückätzen muß die Chemikalie wieder abgespült und der Wafer trockengeschleudert werden, was bei den dünn geschliffenen Scheiben zu Waferbruch führen kann. Außerdem solten aus Umweltschutzgründen naßchemische Verfahren möglichst vermieden werden. Für die Entfernung der Spannungen und Störungen in der Sägekante gibt es bis jetzt kein Verfahren, da naßchemische Siliziumätzmittel auch die ungeschützten Aluminiumpads angreifen würden.

Der vorliegen Erfindung liegt die Aufgabe zugrunde, ein gegenüber den genannten Nachteilen verbessertes Verfahren der eingangs genannten Art anzugeben.

Diese Aufgabe wird durch das Verfahren nach Anspruch 1 gelöst.

Weiterbildungen der Erfindung sind Gegenstand von Unteransprüchen.

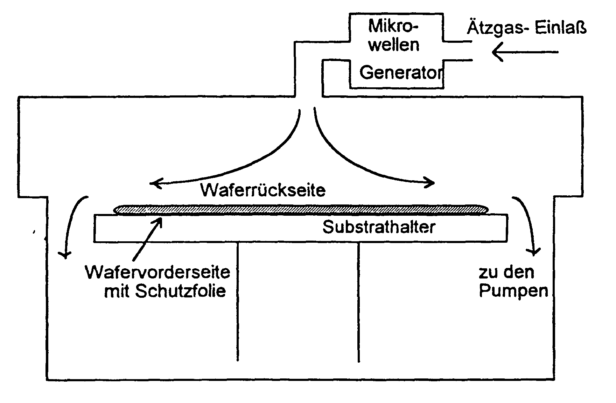

Im folgenden wird die Erfindung anhand eines Ausführungsbeispiels und der einzigen Figur der Zeichnung, die, schematisch und geschnitten, eine zur Durchführung des erfindungsgemäßen Verfahrens geeignete Einzelscheiben-Ätzanlage zeigt, näher erläutert.

Vorteilhaft beim erfindungsgemäßen Verfahren ist zunächst, daß mit vorhandenem Plasmaätz-Equipment, z. B. Tokuda CDE 7, CDE 8 oder Gasonics IPC geätzt werden kann. Das neue Verfahren ist außerdem billiger und umweltfreundlicher und bringt auch in Hinsicht auf mechanische Belastungen der Scheiben eine schonendere Behandlung als beim naßchemischen Ätzen mit sich.

Die wesentlichen Punkte hierbei sind aus der Fig. ersichtlich (Mikrowellen-Version): Falls die Scheibenvorderseite durch die Folie geschützt ist, können die Wafer mit dem Gesicht nach unten herkömmlich transportiert und von oben geätzt werden. Allerdings empfiehlt sich ein Ätzequipment, bei dem die dünn geschliffenen Scheiben mechanisch schonend behandelt werden. Dies ist z. B. der Fall, wenn die Ätzanlage als Schleusenanlage konzipiert ist und in der Einschleuskammer die ganze Horde langsam abgepumpt bzw. belüftet werden kann, während die andere Horde bearbeitet wird.

Für das Ätzen von Silizium auf der Scheibenrückseite stehen bereits verschiedene Mikrowellen- bzw. Hochfrequenz-Plasma-Prozesse zur Verfügung. Dies kann sowohl mit CF₄/O₂-Chemie als auch mit NF₃ oder SF₆/O₂/N₂ (N₂O)-Chemie geschehen. Bisher war immer davon ausgegangen worden, daß mehrere µm abgetragen werden müßten, so daß Plasmaätzverfahren aufgrund der langen Ätzzeiten unwirtschaftlich erschienen. Da die Ätzung erfindungsgemäß, anders als beim Naßätzen, bevorzugt an geschädigten Stellen bzw. entlang von Streßlinien geschieht, ist nur eine kurze Ätzzeit erforderlich (je nach Schleifverfahren und Ätzchemie zwischen 10 sec und 4 min, entsprechend einem Abtragen von rund 200 nm), um den Streß von den Scheiben bzw. aus den Sägekanten zu nehmen. Ersteres läßt sich z. B. über die Messung der Scheibenbiegung kontrollieren. Eine kontrollierte Überätzung verrundet schließlich die Spannungsrisse an ihren Endpunkten, so daß die erforderliche Bruchfestigkeit erreicht wird.

Bei einer Chemical Downstream Ätzung, die bekanntlich durch eine Trennung von Plasmaerzeugungskammer und Probe dazu führt, daß die Scheibe nicht durch elektrische Felder oder durch Ionen belastet wird, also praktisch eine rein chemische Ätzung erfolgt, in der vorgestellten Art ist keine zusätzliche Belackung der Scheibenvorderseite zum Schutz der Randbausteine mehr erforderlich. Selbst wenn diese auf Grund von Haftungsproblemen der Folie für das Ätzgas zugänglich sein sollten, so wird in der genannten kurzen Ätzzeit das Aluminium in den Pads gar nicht und die dicke Oxid/Nitrid-Schutzschicht wegen der hohen Selektivität nur unwesentlich an gegriffen. Aus demselben Grund könnten auch die Sägekanten bei ungeschützter Chipoberfläche mit dem beschriebenen Verfahren damage geätzt werden.

Falls man auf die Vorderseitenfolie ganz verzichten will, kann hier auch das Verfahren zum Vorderseitenschutz Verwendung finden, das in der deutschen Patentanmeldung DE-A-19502777 beschrieben ist. Der Vorderseitenschutz geschieht dabei im wesentlichen durch ein darüberströmendes Neutralgas, das ein Vordringen der Ätzgasteilchen verhindert.

## Patentansprüche

1. Verfahren zur Herstellung von hochintegrierten Schaltungen auf einem scheibenförmigen Silizium - substrat, bei dem die Scheiben dünn geschliffen werden, um dann zu einzelnen Chips zersägt zu werden, und bei dem die durch den Schleifprozeß verursachte Damagezone auf der Scheibenrückseite durch eine bei geschützter Scheibenvorderseite und vor dem Zersägen durchgeführte Ätzung wieder entfernt wird,
**dadurch gekennzeichnet, daß**
die Ätzung als mikrowellen- oder hochfrequenzangeregtes Downstream-Plasmaätzverfahren unter Verwendung von Fluor-Verbindungen im Ätzgas durchgeführt wird, und einem Abtrag von rund 200 nm entspricht.

2. Verfahren nach Anspruch 1,
**dadurch gekennzeichnet, daß**
die Scheibenvorderseite durch ein darüberströmendes Neutralgas geschützt wird.

3. Verfahren nach einem der Ansprüche 1 bis 2,
**dadurch gekennzeichnet, daß**
die Ätzung bis in die Sägekanten der Scheibe hinein erfolgt.

4. Verfahren nach einem der Ansprüche 1 bis 3,
**dadurch gekennzeichnet, daß**
eine Ätzzeit zwischen 10 sec und 4 min gewählt wird.

## Claims

1. Process for producing large-scale integrated circuits on a silicon substrate in wafer form, in which the wafers are ground until they are thin, so that they can be sawn into individual chips, and in which the damage zone on the back surface of the wafers, which is caused by the grinding process, is removed again by etching carried out with the front surface of the wafer protected and before the sawing, **characterized in that** the etching is carried out as microwave-excited or high-frequency-excited downstream plasma etching using fluorine compounds in the etching gas and corresponds to around 200 nm of the material being removed.

2. Process according to Claim 1, **characterized in that** the front surface of the wafer is protected by a neutral gas flowing over it.

3. Process according to one of Claims 1 to 2, **characterized in that** the etching is carried out all the way to the sawn edges of the wafer.

4. Process according to one of Claims 1 to 3, **characterized in that** an etching time of between 10 sec and 4 min is selected.

## Revendications

1. Procédé de fabrication de circuits très intégrés sur un substrat en silicium en forme de tranche, dans lequel on rend mince les tranches en les polissant pour les scier ensuite en des puces individuelles et dans lequel on élimine à nouveau les zones endommagées provoquées par l'opération de polissage sur la face arrière de la tranche par une attaque effectuée alors que la face avant de la tranche est protégée et avant le sciage, **caractérisé en ce qu'**il consiste à effectuer l'attaque sous la forme d'un procédé d'attaque au plasma Downstream excité en micro-ondes ou en haute fréquence en utilisant des composés fluorés dans le gaz d'attaque, l'attaque correspondant à un enlèvement de matière d'environ 200 nm.

2. Procédé suivant la revendication 1, **caractérisé en ce qu'**il consiste à protéger la face avant de la tranche par un gaz neutre qui y passe.

3. Procédé suivant l'une des revendications 1 ou 2, **caractérisé en ce qu'**il consiste à effectuer l'attaque jusque dans les bords de sciage de la tranche.

4. Procédé suivant l'une des revendications 1 à 3, **caractérisé en ce qu'**il consiste à sélectionner une durée d'attaque comprise entre 10 s et 4 min.
